# EUROPÄISCHE PATENTSCHRIFT

(11) **EP 1 206 684 B1**
(45) Veröffentlichungstag und Bekanntmachung des Hinweises auf die Patenterteilung: **03.11.2004**
(21) Anmeldenummer: 00948021.1
(22) Anmeldetag: 03.08.2000
(51) Int. Cl.: G01D 5/249

(54) **POSITIONSMESSEINRICHTUNG**
POSITION-MEASURING DEVICE
DISPOSITIF DE MESURE DE POSITION

(30) Priorität: 03.08.1999 DE 19936582
(43) Veröffentlichungstag der Anmeldung: 22.05.2002
(73) Patentinhaber: Dr. Johannes Heidenhain GmbH, 83292 Traunreut (DE)
(72) Erfinder: SCHWABE, Michael, D-83253 Rimsting (DE)
(86) Internationale Anmeldenummer: PCT/EP2000/007511
(87) Internationale Veröffentlichungsnummer: WO 2001/009568

(56) Entgegenhaltungen:
- WO-A-98/13669
- STEVENSON J T M ET AL: "ABSOLUTE POSITION MEASUREMENT USING OPTICAL DETECTION OF CODED PATTERNS" JOURNAL OF PHYSICS E. SCIENTIFIC INSTRUMENTS,GB,IOP PUBLISHING, BRISTOL, Bd. 21, Nr. 12, 1. Dezember 1988 (1988-12-01), Seiten 1140-1145, XP000004076 ISSN: 0022-3735
- GOTZE S: "SEQUENTIELLE UND ZYKLISCH-SEQUENTIELLE CODIERUNG FUR WINKEL- UND LANGEN-MESSUNGEN" TECHNISCHES MESSEN TM,DE,R.OLDENBOURG VERLAG. MUNCHEN, Bd. 61, Nr. 9, 1. September 1994 (1994-09-01), Seiten 343-345, XP000465893 ISSN: 0171-8096

## Beschreibung

Die Erfindung betrifft eine Positionsmesseinrichtung mit einer Maßverkörperung und einer Abtasteinrichtung zur Abtastung der Maßverkörperung.

Positionsmesseinrichtungen mit einem einspurigen absoluten Code, auch Kettencode oder Pseudo-Random-Code genannt setzten sich immer mehr durch. Die Maßverkörperung besteht dabei aus einer Codespur mit in Messrichtung hintereinander angeordneten Codeelementen gleicher Breite. Die Codeelemente sind in pseudozufälliger Verteilung vorgesehen, so dass eine bestimmte Anzahl von aufeinanderfolgenden Codeelementen jeweils ein Codewort und alle Codeelemente eine kontinuierliche Folge von unterschiedlichen Codewörtern bilden. Ein neues, eine Absolutposition eindeutig definierendes Codewort steht jeweils bereits nach einem Verschiebeweg entsprechend einer Breite eines Codeelementes an. Eine derartige Positionsmesseinrichtung ist beispielsweise in der DE 39 42 625 ausführlich beschrieben.

Dabei ist von Nachteil, dass bei einer relativen langen Maßverkörperung, also bei einem großen Messbereich, relativ lange Bereiche mit gleichartigen Eigenschaften vorliegen. Ist die Positionsmesseinrichtung beispielsweise eine magnetische Messeinrichtung, dann bestehen die Codeelemente aus Nord- und Südpolen. Ein Bereich mit vielen Codeelementen gleicher Magnetisierung erzeugt ein Gleichfeld, das die Auswertung erschwert und das eine benachbart verlaufende Maßverkörperung, insbesondere eine inkrementale Teilung, unerwünscht beeinflusst.

In den Literaturstellen Stevenson J T M and Jordan J R : Absolute position measurement using optical detection of coded pattems, Journal of Physics E. Scientific Instruments, GB, IOP publishing, Bristol, Bd. 21, Nr. 12, 1. Dezember 1988, Seiten 1140-1145 und Götze S: Sequentielle und zyklischsequentielle Codierung für Winkel- und Längenmessungen, Technisches Messen, R. Oldenbourg Verlag, München, Bd. 61, Nr. 9, 1. September 1994, Seiten 343-345 wird darauf hingewiesen, dass mehrere Teitcodes ineinander verschränkt angeordnet werden können. Dadurch kann der Abstand der Abtastelemente vergrößert werden.

Bei der DE 43 09 881 C1 wurde erkannt, dass es nachteilig sein kann, wenn mehrere Codeelemente mit gleichen Eigenschaften direkt nebeneinander in Messrichtung angeordnet sind. Aus diesem Grund wird die Verteilung der Codeelemente invers wiederholt. Die Positionsinformation wird aus der Signaldifferenz gebildet.

Die Positionsmesseinrichtung hat den Nachteil, dass die eigentliche Positionsinformation redundant in der Codespur vorhanden ist und dadurch die Möglichkeit, unterschiedliche Codewörter auf einer vorgegebenen Messlänge vorzusehen, verringert wird.

Den gleichen Nachteil hat die Positionsmesseinrichtung gemäß der JP 3-296620, bei der nach jedem Codewort das dazu inverse Codewort in Messrichtung aufgetragen ist.

Aus der EP 368 605 B1 ist bekannt, eine digitale Positionsinformation in zwei oder mehrere ungefähr gleich lange Fragmente aufzuteilen. Um diese Positionsinformation auf einer Teilung zu speichern, wird das erste Bit des ersten Fragmentes, dann das erste Bit des zweiten Fragmentes bis zum ersten Bit des letzten Fragmentes auf der Teilung gespeichert. Anschließend wird das zweite Bit des ersten Fragmentes, dann das zweite Bit des zweiten Fragmentes bis zum zweiten Bit des letzten Fragmentes auf der Teilung gespeichert. Dies wird wiederholt, bis die gesamte Positionsinformation gespeichert wurde. Dadurch werden die Positionsinformationen der einzelnen Fragmente ineinander verschachtelt. Dadurch ist noch nicht gewährleistet, dass möglichst wenige gleichartige Codeelemente direkt aufeinanderfolgend in Messrichtung angeordnet sind.

Es ist daher die Aufgabe der Erfindung, eine Positionsmesseinrichtung anzugeben, bei der eine Vielzahl aufeinanderfolgender Codeelemente mit gleicher Eigenschaft vermieden werden soll und trotzdem ein großer Messbereich absolut codiert werden kann.

Diese Aufgabe wird durch die Positionsmesseinrichtung mit den Merkmalen des Anspruchs 1 gelöst.

Weiterbildungen und vorteilhafte Ausgestaltungen sind in den abhängigen Ansprüchen angegeben.

Die erfindungsgemäße Positionsmesseinrichtung weist den Vorteil auf, dass nur wenige aneinandergrenzende Codeelemente gleiche Eigenschaften aufweisen.

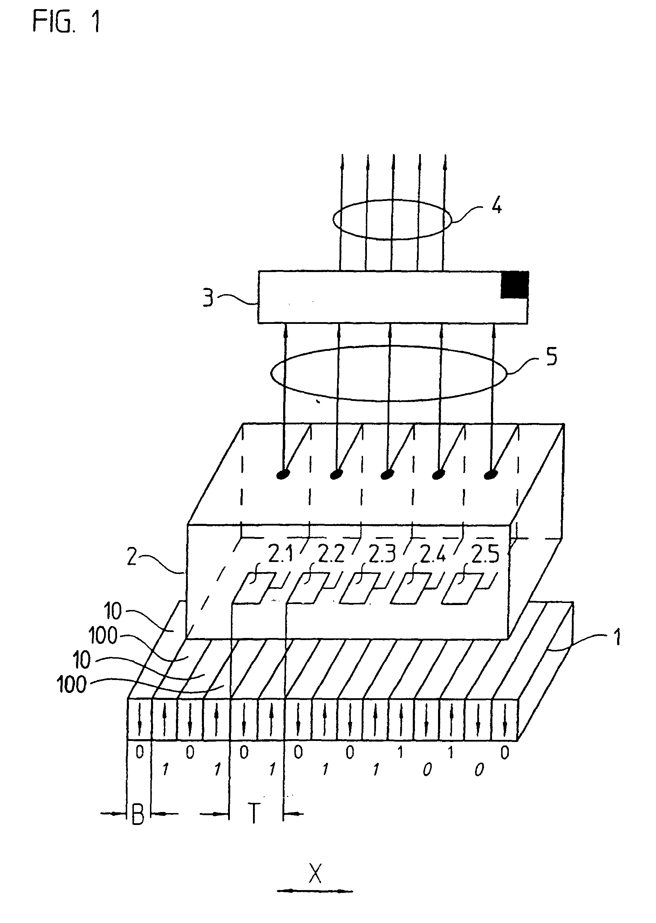

Die Erfindung wird nachfolgend anhand der Zeichnung näher erläutert, es zeigt
- Figur 1: eine erfindungsgemäße Positionsmesseinrichtung mit einer einspurigen magnetischen Maßverkörperung.

Die Erfindung wird anhand der Figur 1 und den Tabellen 1 und 2 an einem Beispiel erläutert, bei dem eine Maßverkörperung 1 mit magnetischen Codeelementen 10, 100 von einer Abtasteinrichtung 2 abgetastet wird. Die Codeelemente 10, 100 sind magnetische Pole unterschiedlicher Magnetisierung, welche durch die Richtung der Pfeile schematisch dargestellt ist.

Die Absolutposition 4 ist unter Benutzung eines einspurigen Codes mit einer Breite der Codewörter von fünf Codeelementen eindeutig bestimmt. Ausgehend von einer binären Codierung gemäß dem Dualsystem mit einer Codewortbreite von fünf Codeelementen 10 ist ein üblicher serieller Code durch eine Folge von Codeelementen 10 (Physikalische Reihefolge) gemäß Tabelle 1 definiert. Dieser Code wird auch Kettencode oder Pseudo-Random-Code genannt. Ein mit "0" gekennzeichnetes Codeelement 10 ist beispielsweise ein Südpol und ein mit "1" gekennzeichnetes Codeelement ein Nordpol, der Nordpol weist also gegenüber dem Südpol eine invertierte Eigenschaft auf.

Mit der Codewortbreite von fünf Codeelementen 10 lassen sich 32 unterschiedliche Codewörter bilden, die wiederum 32 unterschiedliche Absolutpositionen 4 codieren können. Aus Tabelle 1 ist ersichtlich, dass die Reihenfolge der Codeelemente 10 derart gewählt ist, dass bei einer Verschiebung der Abtasteinheit 2 um die Breite B eines Codeelementes 10 wieder ein eindeutiges, also von den übrigen Codewörtern abweichendes Codewort vorliegt.

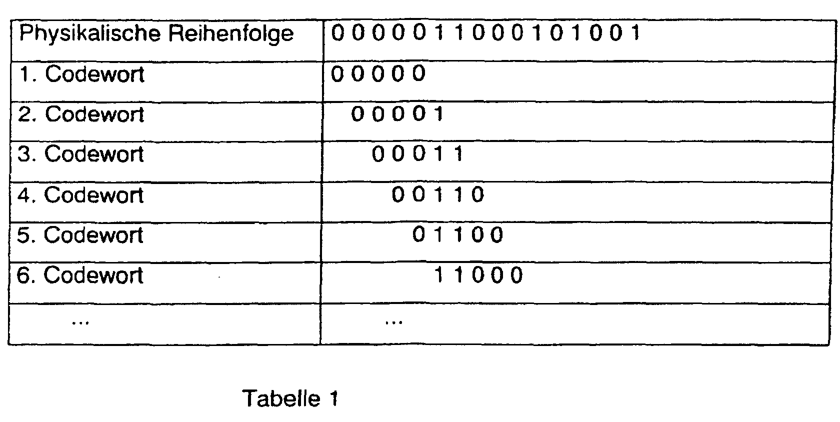

Die Folge der Codeelemente 10 in Tabelle 1 weist mehrfach unmittelbar aufeinander folgende Codeelemente 10 mit gleichen Eigenschaften, im Beispiel gleicher Magnetisierung, auf. So sind die ersten fünf Codeelemente 10 jeweils identisch. Dieser relativ große in Messrichtung X ausgedehnte homogene Bereich erzeugt ein großes Gleichfeld, das zu unerwünschten Beeinflussungen, insbesondere einer inkrementalen Nachbarspur führen kann bzw. eine optimierte Auslegung der Abtasteinrichtung 2 erschwert.

Damit möglichst wenig aufeinander folgende Codeelemente 10 gleiche Eigenschaften aufweisen, ist erfindungsgemäß nach jedem Codeelement 10 das dazu invertierte Codeelement 100 in die Folge von Codeelementen 10 eingefügt, wie dies in Tabelle 2 für den gleichen Ausschnitt der Codefolge wie in Tabelle 1 dargestellt ist. Invertierte Codeelemente 100 sind kursiv dargestellt. Dabei kann auch die Reihenfolge von ursprünglichem und invertiertem Codeelement 10, 100 vertauscht werden, so dass zunächst das invertierte und dann das ursprüngliche Codeelement 10, 100 in der Codefolge angeordnet ist. Die ursprünglichen Codeelemente 10 und die dazu invertierten Codeelemente 100, die jeweils an gleicher Stelle des Codewortes stehen, werden abwechselnd aufeinander folgend angeordnet. Die somit entstehende Folge von Codeelementen 10, 100 ist in Tabelle 2 dargestellt.

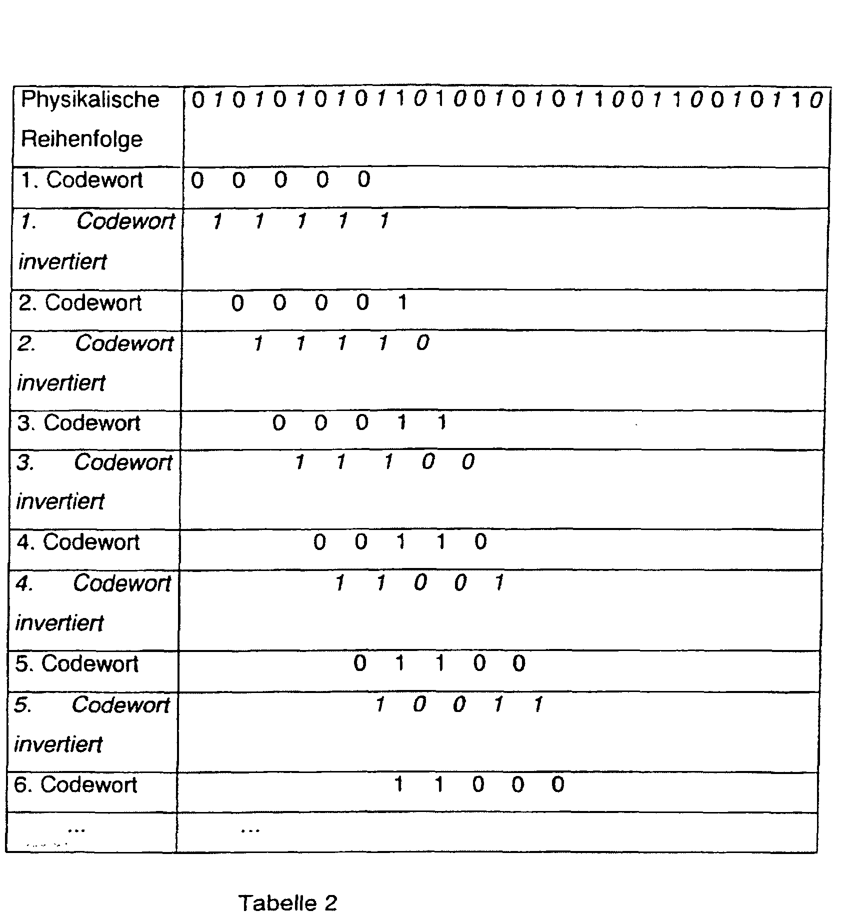

Durch das Vorsehen des jeweils invertierten Codeelementes 100 nach einem ursprünglichen Codeelement 10 in der physikalischen Folge auf der Maßverkörperung 1 ist sichergestellt, dass maximal zwei aufeinander folgende Codeelemente 10, 100 identische Eigenschaften, beispielsweise gleiche Magnetisierung, haben. Da auch aus den invertierten Codeelementen 100 ein Codewort und somit eine Absolutposition 4 eindeutig detektierbar ist, wird die aufgrund der Anzahl der Codeelemente 10, 100 pro Codewort maximal codierbare Information voll ausgenutzt.

Zur Abtastung der Codeelemente 10, 100 der Maßverkörperung 1 beinhaltet die Abtasteinrichtung 2 fünf Detektorelemente 2.1, 2.2, 2.3, 2.4, 2.5, die jeweils in einem gegenseitigen Abstand T von zwei Codeelementen 10, 100 angeordnet sind. Dadurch wird sichergestellt, dass ein Codewort entweder nur aus ursprünglichen Codeelementen 10 oder nur aus invertierten Codeelementen 100 abgeleitet wird, da alle Detektorelemente 2.1 bis 2.5 entweder den ursprünglichen oder den invertierten Codeelementen 10, 100 gegenüberstehen.

In an sich bekannter Weise werden die Abtastsignale der Detektorelemente 2.1 bis 2.5 dazu benutzt, um einen Speicher 3 zu adressieren. Im Speicher 3 werden die Abtastsignale 5 in Absolutpositionen 4 umcodiert.

Aus der physikalischen Reihenfolge der Codeelemente 10, 100 gemäß Tabelle 2 wird somit in der ersten Position das erste Codewort (00000) als erste Absolutposition 4 decodiert, bewegt sich die Abtasteinrichtung 2 um ein Codeelement 10, 100, also um B weiter, wird das "1. Codewort invertiert" (11111) als zweite Absolutposition 4 decodiert, bewegt sich die Abtasteinrichtung 2 um eine weiteres Codeelement weiter, wird das 2. Codewort (00001) als dritte Absolutposition 4 decodiert, bewegt sich die Abtasteinrichtung 2 um eine weiteres Codeelement weiter, wird das "2. Codewort invertiert" (11110) als vierte Absolutposition 4 decodiert.

Die Folge des in Tabelle 2 gezeigten Codes besteht aus zwei Reihen von Codewörtern, wobei eine Reihe von Codewörtern einen einschrittigen Code bildet, der aber nur den halben der Bitlänge entsprechenden Zahlenraum (bei 5 Bits: 16 Codewörter) umfasst. Diese Codewörter sind unterschiedlich und keines der Codewörter ist zu einem der anderen Codewörter invers.

Die zweite Reihe von Codewörtern ist durch Invertieren der Codeelemente der Codewörter der ersten Reihe erzeugt und sie bildet den weiteren halben der Bitlänge entsprechenden Zahlenraum.

Die Folge des Gesamtcodes erfolgt durch Ineinanderschachteln derart, dass ein invertiertes Codewort in ein zugehöriges Codewort eingefügt wird, dieses Einfügen kann auch als Verschränken bezeichnet werden, so dass sich Codewort und sein invertiertes Codewort in der Folge überlappen.

Die Häufigkeit der Anordnung gleichartiger Codeelemente 10, 100 kann auch vermindert werden, wenn die invertierten Codeelemente 100 jeweils nicht unmittelbar auf das unveränderte Codeelement 10 eingefügt werden, sondern jeweils erst nach einem oder mehreren Codeelementen 10. Wird davon ausgegangen, dass ein Codewort aus jeweils M > 1 Codeelementen besteht, so können zwischen jeweils zwei Codeelementen 10 eines ersten Codewortes N Codeelemente N weiterer Codewörter eingefügt sein, mit 0 < N < M. Um einen Wechsel der Eigenschaften der Codeelemente 10, 100 in der Folge zu erreichen, sind die Codeelemente 100 eines der eingefügten Codewörter gegenüber den Codeelementen 10 des ersten Codewortes invers ausgebildet.

Zur Bildung der Absolutposition 4 ist der gegenseitige Abstand T der Detektorelemente der Abtasteinrichtung 2 (N + 1) mal die Breite B eines Codeelementes 10, 100.

Die Erfindung ist bei Längen- und Winkelmesseinrichtungen einsetzbar. Beim Einsatz in Winkelmesseinrichtungen ist die Verwendung geschlossener Reihen von Codewörtern vorteilhaft. Dabei kann das Ende einer Reihe von Codewörtern nahtlos an ihren Anfang angeschlossen werden. Auch im Übergangsbereich zwischen Anfang und Ende ist an jeder Position eine eindeutige Absolutposition detektierbar. Die Codeelemente können auf einer Scheibe oder am Umfang einer Trommel zu einer Drehachse symmetrisch angeordnet sein.

Besonders vorteilhaft ist die Erfindung bei M größer oder gleich 7 und N gleich 1 einsetzbar.

Die Vorteile der Erfindung ergeben sich besonders offensichtlich bei einer magnetischen Maßverkörperung, bei der die Codeelemente 10, 100 aus Magnetpolen gleicher Breite B besteht. Die Magnetpole können dabei auf der Basis kunststoffgebundener Magnete oder metallischer bzw. keramischer Hartmagnete realisiert sein. Die Detektorelemente 2.1 bis 2.5 sind vorteilhafterweise Hallelemente, es sind aber auch magnetoresistive Sensoren oder Sensoren mit großem Magnetwiderstand einsetzbar.

Die Erfindung ist aber auch bei optischen, kapazitiven oder induktiven Positionsmesseinrichtungen vorteilhaft einsetzbar. Bei optischen Positionsmesseinrichtungen bestehen die Codeelemente aus transparenten bzw. reflektierenden Bereichen und dazu inversen nicht transparenten bzw. nicht reflektierenden Bereichen gleicher Breite B.

Die oben als invers definierte Eigenschaft kann auch als komplementär bezeichnet werden, wobei in Abhängigkeit des physikalischen Abtastprinzips das Codeelement 10 und das dazu inverse Codeelement 100 komplementäre physikalische Eigenschaften - im Beispiel gegensinnige Richtung der Magnetisierung - aufweisen.

In nicht gezeigter Weise ist es vorteilhaft, neben der Folge der Codeelemente 10, 100 eine periodische inkrementale Teilung anzuordnen, so dass nach bekannten Interpolationsverfahren die Position der Abtasteinrichtung 2 gegenüber der Maßverkörperung 1 auch innerhalb eines Codeelementes 10, 100 mit hoher Auflösung angegeben werden kann.

## Patentansprüche

1. Positionsmesseinrichtung mit einer Maßverkörperung (1) und einer Abtasteinrichtung (2) zur Abtastung der Maßverkörperung (1), wobei
- die Maßverkörperung (1) aus einem Code aus einer Folge von Codeelementen (10, 100) besteht, die mehrere jeweils eine Absolutposition (4) definierende Codewörter bilden;
- mehrere Codewörter ineinander verschränkt angeordnet sind, indem in die Folge der Codeelemente (10) eines Codewortes Codeelemente (100) eines weiteren Codewortes eingefügt sind, **dadurch gekennzeichnet, dass**
- die Codeelemente (10) des einen Codewortes zu den Codeelementen (100) eines benachbarten Codewortes komplementär sind.

2. Positionsmesseinrichtung nach Anspruch 1, **dadurch gekennzeichnet, dass** ein Codewort jeweils aus M > 1 Codeelementen (10) besteht und zwischen jeweils zwei Codeelementen (10) eines Codewortes N Codeelemente (100) N weiterer Codewörter eingefügt sind, wobei 0 < N < M und die Codeelemente (10) des Codewortes zu den Codeelementen (100) eines der eingefügten Codewörter invertierte Eigenschaften aufweisen.

3. Positionsmesseinrichtung nach Anspruch 2, **dadurch gekennzeichnet, dass** die Abtasteinrichtung (2) M Detektoretemente (2.1, 2.2, 2.3, 2.4, 2.5) zur Abtastung der Codeelemente (10, 100) aufweist, und der gegenseitige Abstand (T) der Detektorelemente (2.1, 2.2, 2.3, 2.4, 2.5) zur Bildung eines Codewortes jeweils (N + 1) mal der Breite (B) eines Codeelementes (10, 100) ist.

4. Positionsmesseinrichtung nach Anspruch 2 oder 3, **dadurch gekennzeichnet, dass** M ≥ 8 und N = 1 ist.

5. Positionsmesseinrichtung nach einem der vorhergehenden Ansprüche, **dadurch gekennzeichnet, dass** die Codeelemente (10, 100) Magnetpole sind und die Detektorelemente (2.1, 2.2, 2.3, 2.4, 2.5) Hallelemente sind.

6. Positionsmesseinrichtung nach einem der vorhergehenden Ansprüche, **dadurch gekennzeichnet, dass** der Code aus zwei ineinander verschränkten Reihen von Codewörtern besteht, wobei eine Reihe von Codewörtern einen einschrittigen Code bildet, der den halben der Bitlänge eines Codewortes entsprechenden Zahlenraum umfasst, die zweite Reihe von Codewörtern die invertierten Codeelemente der ersten Reihe sind und diese den weiteren halben der Bitlänge eines Codewortes entsprechenden Zahlenraum umfasst.

## Claims

1. Position measuring device having a measurement representation (1) and a scanning device (2) for scanning the measurement representation (1),
- the measurement representation (1) comprising a code of a sequence of code elements (10, 100) which form a plurality of codewords respectively defining an absolute position (4);
- a plurality of codewords is arranged interlaced with each other by code elements (100) of a further codeword being inserted into the sequence of code elements (10), **characterised in that**
- the code elements (10) of the one codeword are complementary to the code elements (100) of an adjacent codeword.

2. Position measuring device according to claim 1, **characterised in that** a codeword comprises in each case M > 1 code elements (10) and N code elements (1700) of N further codewords are inserted between respectively two code elements (10) of a codeword, 0 being < N < M and the code elements (10) of the codeword having inverse properties with respect to the code elements (100) of one of the inserted codewords.

3. Position measuring device according to claim 2, **characterised in that** the scanning device (2) has M detector elements (2.1, 2.2, 2.3, 2.4, 2.5) for scanning the code elements (10, 100), and the mutual spacing (T) of the detector elements (2.1, 2.2, 2.3, 2.4, 2.5) for forming a codeword is in each case (N +1) times the width (B) of a code element (10, 100)

4. Position measuring device according to claim 2 or 3, **characterised in that** M ≥ 8 and N = 1.

5. Position measuring device according to one of the preceding claims, **characterised in that** the code elements (10, 100) are magnetic poles and the detector elements (2.1, 2.2, 2.3, 2.4, 2.5) are Hall elements.

6. Position measuring device according to one of the preceding claims, **characterised in that** the code comprises two interlaced rows of codewords, one row of codewords forming a single-step code which comprises half the numerical space corresponding to the bit length of a codeword, the second row of codewords being the inverted code elements of the first row and comprising the further half of the numerical space corresponding to the bit length.

## Revendications

1. Dispositif de mesure de position comprenant une mesure matérialisée (1) et un dispositif de palpage (2) destiné à explorer la mesure matérialisée (1), dans lequel
- la mesure matérialisée (1) est constituée d'un code formé d'une suite d'éléments de code (10, 100) qui forment plusieurs mots-codes définissant chacun une position absolue (4);
- plusieurs mots-codes sont disposés de manière mutuellement entrelacée, par le fait que dans la suite des éléments de code (10) d'un mot-code sont insérés des éléments de code (100) d'un autre mot-code, **caractérisé en ce que**
- les éléments de code (10) d'un mot-code sont complémentaires des éléments de code (100) d'un mot-code voisin.

2. Dispositif de mesure de position selon la revendication 1, **caractérisé en ce qu'**un mot-code est formé respectivement de M > 1 éléments de code (10) et N éléments de code (100) de N autres mots-codes sont insérés entre deux éléments de code (10) d'un mot-code, avec 0 < N < M et les éléments de code (10) du mot-code présentant des propriétés inversées par rapport aux éléments de code (100) de l'un des mots-codes insérés.

3. Dispositif de mesure de position selon la revendication 2, **caractérisé en ce que** le dispositif de palpage (2) présente M éléments détecteurs (2.1, 2.2, 2.3, 2.4, 2.5) destinés à palper les éléments de code (10, 100) et **en ce que** la distance (T) réciproque des éléments détecteurs (2.1, 2.2, 2.3, 2.4, 2.5) pour former un mot-code est chaque fois (N + 1) fois la largeur (B) d'un élément de code (10, 100).

4. Dispositif de mesure de position selon la revendication 2 ou 3, **caractérisé en ce que** M ≥ 8 et N = 1.

5. Dispositif de mesure de position selon une des revendications précédentes, **caractérisé en ce que** les éléments de code (10, 100) sont des pôles magnétiques et les éléments détecteurs (2.1, 2.2, 2.3, 2.4, 2.5) des éléments de Hall.

6. Dispositif de mesure de position selon une des revendications précédentes, **caractérisé en ce que** le code est constitué de deux séries entrelacées de mots-codes, l'une des séries de mots-codes formant un code cyclique qui englobe la moitié de l'espace numérique correspondant à la longueur binaire d'un mot-code, la deuxième série de mots-codes étant formée des éléments de code inversés de la première série et englobant l'autre moitié de l'espace numérique correspondant à la longueur binaire d'un mot-code.
